Europäisches Patentamt

European Patent Office

Office européen des brevets

(11) Veröffentlichungsnummer: **0 298 330**
**A2**

## (12) EUROPÄISCHE PATENTANMELDUNG

(21) Anmeldenummer: 88110185.1

(22) Anmeldetag: 25.06.88

(51) Int. Cl.⁴: **H03K 17/945**

(30) Priorität: 07.07.87 DE 3722335

(43) Veröffentlichungstag der Anmeldung:
**11.01.89 Patentblatt 89/02**

(84) Benannte Vertragsstaaten:
**CH DE FR GB LI SE**

(71) Anmelder: **i f m electronic gmbh**
**Teichstrasse 4**
**D-4300 Essen 1(DE)**

(72) Erfinder: **Lamarche, Jean-Luc, Dipl.-Ing.**
**Zeppelinstrasse 1**
**D-7994 Langenargen(DE)**

(74) Vertreter: **Gesthuysen, Hans Dieter, Dipl.-Ing.**
**et al**
**Patentanwälte Gesthuysen + von Rohr**
**Huyssenallee 15 Postfach 10 13 33**
**D-4300 Essen 1(DE)**

(54) Elektronisches, vorzugsweise berührungslos arbeitendes Schaltgerät.

㉗ Dargestellt und beschrieben ist ein elektronisches, berührungslos arbeitendes Schaltgerät (1), mit einem von außen beeinflußbaren Anwesenheitsindikator (10), mit einem dem Anwesenheitsindikator (10) nachgeordneten Schaltverstärkers (11), mit einem von dem Anwesenheitsindikator (10) über den Schaltverstärker (11) steuerbaren elektronischen Schalter (12), mit einer Speiseschaltung (13) zur Darstellung der Speisespannung für den Anwesenheitsindikator (10) und für den Schaltverstärker (11) und mit einer Einschaltimpulse verhindernden Verzögerungsschaltung (14), wobei die Speiseschaltung (13) einen Spannungs- und/oder Stromregler (16) aufweist.

Bei dem erfindungsgemäßen elektronischen Schaltgerät (1) werden mit noch größerer Sicherheit als im Stand der Technik Einschaltimpulse verhindert, und zwar dadurch, daß die Verzögerungsschaltung (14) erst wirksam wird, nämlich die Verzögerungszeit erst zu laufen beginnt, wenn der Spannungs- und/oder Stromregler (16) zu arbeiten begonnen hat.

Fig.1

# Elektronisches, vorzugsweise berührungslos arbeitendes Schaltgerät

Die Erfindung betrifft ein elektronisches, vorzugsweise berührungslos arbeitendes Schaltgerät, mit einem von außen beeinflußbaren Anwesenheitsindikator, z. B. einem Oszillator, mit einem dem Anwesenheitsindikator nachgeordneten Schaltverstärker, mit einem von dem Anwesenheitsindikator über den Schaltverstärker steuerbaren elektronischen Schalter, z. B. einem Transistor, einem Thyristor oder einem Triac, mit einer Speiseschaltung zur Darstellung der Speisespannung für den Anwesenheitsindikator und für den Schaltverstärker und mit einer Einschaltimpulse verhindernden Verzögerungsschaltung.

Elektronische Schaltgeräte der hier grundsätzlich in Rede stehenden Art sind kontaktlos ausgeführt und werden seit nunmehr etwa zwanzig Jahren in zunehmendem Maße anstelle von elektrischen, mechanisch betätigten Schaltgeräten, die kontaktbehaftet ausgeführt sind, verwendet, insbesondere in elektrischen bzw. elektronischen Meß-, Steuer- und Regelkreisen. Das gilt insbesondere für sogenannte Annäherungsschalter, d. h. für elektronische Schaltgeräte, die berührungslos arbeiten. Mit solchen Annäherungsschaltern wird indiziert, ob sich ein Beeinflussungselement, für das der entsprechende Annäherungsschalter sensitiv ist, dem Annäherungsschalter hinreichend weit genähert hat. Hat sich nämlich ein Beeinflussungselement, für das der entsprechende Annäherungsschalter sensitiv ist, dem Annäherungsschalter hinreichend weit genähert, so steuert der einen wesentlichen Bestandteil des Annäherungsschalters bildende Anwesenheitsindikator den elektronischen Schalter um; bei einem als Schließer ausgeführten Schaltgerät wird der nichtleitende elektronische Schalter nunmehr leitend, während bei einem als Öffner ausgeführten Schaltgerät der leitende elektronische Schalter nunmehr sperrt. (Mit Schaltgeräten der in Rede stehenden Art kann auch indiziert werden, ob eine physikalische Größe eines Beeinflussungsmediums, für die das Schaltgerät sensitiv ist, einen entsprechenden Wert erreicht hat.)

Wesentlicher Bestandteil von elektronischen Schaltgeräten der zuvor beschriebenen Art ist also u. a. der von außen beeinflußbare Anwesenheitsindikator.

Als Anwesenheitsindikator kann z. B. ein induktiv oder kapazitiv beeinflußbarer Oszillator vorgesehen sein; es handelt sich dann um induktive oder kapazitive Annäherungsschalter (vgl. z. B. die deutschen Offenlegungsschriften bzw. Auslegeschriften bzw. Patentschriften 19 51 137, 19 66 178, 19 66 213, 20 36 840, 21 27 956, 22 03 038, 22 03 039, 22 03 040, 22 03 906, 23 30 233, 23 31 732, 23 56 490, 26 13 423, 26 16 265, 26 16 773, 26 28 427, 27 11 877, 27 44 785, 29 43 911, 30 04 829, 30 38 692, 31 20 884, 32 09 673, 32 38 396, 33 20 975, 33 26 440, 33 27 329, 34 20 236, 34 27 498, 35 19 714, 36 05 499 und 36 38 409). Als Anwesenheitsindikator kann auch ein Fotowiderstand, eine Fotodiode oder ein Fototransistor vorgesehen sein; es handelt sich dann um optoelektronische Annäherungsschalter (vgl. z. B. die deutschen Offenlegungsschriften 28 24 582, 30 38 102, 33 37 328, 35 14 643, 35 18 025 und 36 05 885).

Bei induktiven Annäherungsschaltern gilt für den Oszillator, solange ein Metallteil einen vorgegebenen Abstand noch nicht erreicht hat, K x V = 1 mit K = Rückkopplungsfaktor und V = Verstärkungsfaktor des Oszillators, d. h. der Oszillator schwingt. Erreicht das entsprechende Metallteil den vorgeschriebenen Abstand, so führt die zunehmende Bedämpfung des Oszillators zu einer Verringerung des Verstärkungsfaktors V, so daß K x V < 1 wird, d. h. der Oszillator hört auf zu schwingen. Bei kapazitiven Annäherungsschaltern gilt für den Oszillator, solange ein Ansprechkörper die Kapazität zwischen einer Ansprechelektrode und einer Gegenelektrode noch nicht hinreichend vergrößert hat, also einen vorgegebenen Abstand noch nicht erreicht hat, K x V < 1, d. h. der Oszillator schwingt nicht. Erreicht der Ansprechkörper den vorgegebenen Abstand, so führt die steigende Kapazität zwischen der Ansprechelektrode und der Gegenelektrode zu einer Vergrößerung des Rückkopplungsfaktors K, so daß K x V = 1 wird, d. h. der Oscillator beginnt zu schwingen. Bei beiden Ausführungsformen - induktiver Annäherungsschalter und kapazitiver Annäherungsschalter - wird abhängig von den unterschiedlichen Zuständen des Oszillators der elektronische Schalter, z. B. ein Transistor, ein Thyristor oder ein Triac, gesteuert.

Optoelektronische Annäherungsschalter weisen einen Lichtsender und einen Lichtempfänger auf und werden auch als Lichtschranken bezeichnet. Dabei unterscheidet man zwischen einem Lichtschrankentyp, bei dem Lichtsender und der Lichtempfänger auf entgegengesetzten Seiten einer Überwachungsstrecke angeordnet sind, und einem Lichtschrankentyp, bei dem der Lichtsender und der Lichtempfänger am gleichen Ende einer Überwachungsstrecke angeordnet sind, während ein am anderen Ende der Überwachungsstrecke angeordneter Reflektor den vom Lichtsender ausgehenden Lichtstrahl zum Lichtempfänger zurückreflektiert. In beiden Fällen spricht der Anwesenheitsindikator an, wenn die normalerweise vom Lichtsender zum Lichtempfänger gelangende Lichtstrahl durch ein in die Überwachungsstrecke gelangtes Beeinflussungselement unterbrochen wird. Es gibt jedoch auch Lichtschranken des zuletzt beschriebenen Lichtschrankentyps, bei dem der vom Lichtsender kommende Lichtstrahl nur durch ein entsprechendes Beeinflussungselement zum Lichtempfänger zurückreflektiert wird.

Elektronische, berührungslos arbeitende Schaltgeräte sind anfangs mit einer Reihe von Problemen behaftet gewesen, - gemessen an elektrischen, mechanisch betätigten Schaltgeräten -, nämlich u. a. mit dem Problemen "Darstellung einer Speisespannung für den Anwesenheitsindikator und den Schaltverstärker", "Ausbildung des Anwesenheitsindikators", "Kurzschlußfestigkeit" und "Einschaltimpulsverhinderung". Mit diesen Problemen und deren Lösungen (und mit anderen bei elektronischen, berührungslos arbeitenden Schaltgeräten relevanten Problemen und deren Lösungen) befassen sich z. B. die deutschen Offenlegungsschriften bzw. Auslegeschriften bzw. Patentschriften (19 51 137, 19 66 178, 19 66 213, 20 36 840, 21 27 956, 22 03 039, 22 03 040, 22 03 906, 23 30 233, 23 31 732, 23 56 490, 26 13 423, 26 16 265, 26 16 773, 26 28 427, 27 11 877, 27 44 785, 29 43 911, 30 04 829, 30 38 102, 30 38 141, 30 38 692, 31 20 884, 32 05 737, 32 09 673, 32 14 836, 32 38 396, 33 20 975, 33 26 440, 33 27 328, 33 27 329, 34 20 236, 34 27 498, 35 19 714, 35 29 827, 36 05 199, 36 05 885 und 36 38 409).

Bei elektronischen Schaltgeräten, die über einen Außenleiter mit einem Pol einer Betriebsspannungsquelle und nur über einen weiteren Außenleiter mit einem Anschluß eines Verbrauchers verbindbar sind, ist die Darstellung einer Speisespannung bzw. eines Speisestroms für den Anwesenheitsindikator und für den Schaltverstärker nicht problemlos, weil ja sowohl im leitenden Zustand als auch im gesperrten Zustand des Schaltgerätes die Speisespannung bzw. der Speisestrom dargestellt werden muß.

Es ist belanglos, ob man von Darstellung einer Speisespannung oder von Darstellung eines Speisestroms spricht. Darstellung steht hier für Ableitung aus dem am Schaltgerät auftretenden Spannungsabfall bzw. aus dem über das Schaltgerät geführten Betriebsstrom (leitender Zustand) bzw. aus der am Schaltgerät anstehenden Betriebsspannung bzw. aus dem über das Schaltgerät fließenden Reststrom (gesperrter Zustand). Es ist deshalb belanglos, ob man von Darstellung einer Speisespannung oder von Darstellung eines Speisestroms spricht, weil Anwesenheitsindikator und der Schaltverstärker selbstverständlich eine Speisespannung und einen Speisestrom benötigen.

Von ihrer Funktion als Schaltgeräte her soll bei den in Rede stehenden Schaltgeräten im leitenden Zustand praktisch kein Spannungsabfall auftreten und im gesperrten Zustand praktisch kein Reststrom fließen. Da aber dann, wenn bei Schaltgeräten mit nur zwei Außenleitern im leitenden Zustand kein Spannungsabfall aufträte, auch keine Speisespannung für den Anwesenheitsindikator und den Schaltverstärker gewonnen werden könnte, und dann, wenn im gesperrten Zustand kein Reststrom flösse, auch kein Speisestrom gewonnen werden könnte, gilt für alle elektronischen Schaltgeräte mit nur zwei Außenleitern, daß im leitenden Zustand ein Spannungsabfall auftritt und im gesperrten Zustand ein Reststrom fließt.

Aus dem, was zuvor ausgeführt worden ist, folgt, daß dann, wenn schon, ungewollt, aber funktionsnotwendig bei elektronischen Schaltgeräten mit nur zwei Außenleitern im leitenden Zustand ein Spannungsabfall auftritt und im gesperrten Zustand ein Reststrom fließt, der Spannungsabfall und der Reststrom so gering wie möglich sein sollen.

Einleitend ist gesagt, daß zu dem elektronischen Schaltgerät, von dem die Erfindung ausgeht, u. a. ein dem Anwesenheitsindikator nachgeordneter Schaltverstärker und ein elektronischer Schalter gehören und daß der elektronische Schalter von dem Anwesenheitsindikator über den Schaltverstärker steuerbar ist. Schaltverstärker ist hier ganz allgemein zu verstehen und umfaßt die gesamte Schaltung zwischen dem Signalausgang des Anwesenheitsindikators und dem Steuereingang des elektronischen Schalters, also den gesamten Signalübertragungsweg zwischen dem Anwesenheitsindikator und dem elektronischen Schalter. Selbstverständlich kann der so verstandene Schaltverstärker bzw. der Signalübertragungsweg aus mehreren Funktionseinheiten bestehen.

Für elektronische Schaltgeräte der in Rede stehenden Art mit einem Oszillator als Anwesenheitsindikator gilt nun folgendes:

Wird ein solches Schaltgerät an die Betriebsspannungsquelle angeschlossen, so ist - ohne besondere Maßnahmen - der Schaltverstärker bereits betriebsbereit, wenn der Oszillator, noch nicht betriebsbereit ist. Tatsächlich benötigt nämlich der Oszillator, nachdem die Speisespannung an ihm den erforderlichen Minimalwert erreicht hat, eine bestimmte Zeit zum Aufbau der Oszillatorschwingungen, während der Schaltverstärker, nachdem die Speisespannung an ihm den erforderlichen Minimalwert erreicht hat, praktisch sofort betriebsbereit ist. Das führt nun dazu, daß beim Anschließen eines solchen Schaltgerätes an die Betriebsspannungsquelle eine Beeinflussung, nämlich eine Bedämpfung des Oszillators vorgetäuscht wird und das Schaltgerät entsprechend reagiert, nämlich bei einem als Schließer ausgeführten Schaltgerät der elektronische Schalter leitend wird und bei einem als Öffner ausgeführten Schaltgerät der elektronische Schalter sperrt.

Das zuvor beschriebene Phänomen ist schon vor etwa zwanzig Jahren erkannt worden und wird allgemein als "Auftreten von Einschaltimpulsen" bezeichnet. Solche Einschaltimpulse lassen sich durch eine Verzögerungsschaltung verhindern. Zu dem bekannten elektronischen Schaltgerät, von dem die Erfindung ausgeht, gehört folglich auch eine Einschaltimpulse verhindernde Verzögerungsschaltung.

Weiter oben ist ausgeführt, daß die erläuterten Einschaltimpulse dann auftreten, wenn der Anwesenheitsindikator als Oszillator ausgeführt ist. Einschaltimpulse treten jedoch auch dann auf, wenn der Anwesenheitsindikator anders denn als Oszillator ausgeführt ist, nämlich immer dann, wenn der Anwesenheitsindikator eine bestimmte Zeit benötigt, um betriebsbereit zu werden. Im folgenden wird immer ein elektronisches Schaltgerät mit einem Oszillator als Anwesenheitsindikator beschrieben. Gleichwohl gilt das Gesagte allgemein, nämlich für alle elektronischen Schaltgeräte der in Rede stehenden Art, die einen Anwesenheitsindikator aufweisen, der eine bestimmte Zeit benötigt, um Betriebsbereit zu werden.

Im Stand der Technik hat man zunächst die Einschaltimpulse verhindernde Verzögerungsschaltung direkt an den Signalübertragungsweg - zwischen dem Anwesenheitsindikator und dem elektronischen Schalter - angeschlossen (vgl. das JP-GM 42-2278 und die DE-AS 20 54 100). Das ist insoweit nachteilig, daß die Verzögerungsschaltung nicht nur beim Anschließen eines solchen Schaltgerätes an die Betriebsspannungsquelle wirksam wird, vielmehr ständig wirksam ist und damit die maximale Schaltfrequenz eines solchen Schaltgerätes begrenzt.

Den zuvor aufgezeigten Nachteil hat man bereits 1973 erkannt und deshalb ein elektronisches Schaltgerät der in Rede stehenden Art verwirklicht, bei dem dem Schaltverstärker bzw. einer Funktionseinheit des Schaltverstärkers die Verzögerungsschaltung speisespannungsmäßig vorgeschaltet ist (vgl. die DE-AS 23 56 490). Hier ist gewährleistet, daß die Verzögerungsschaltung nur beim Anschließen eines solchen Schaltgerätes an die Betriebsspannungsquelle wirksam ist, so daß damit die maximale Schaltfrequenz des Schaltgerätes nicht beeinflußt wird. Äquivalent dazu ist eine ebenfalls bereits bekannte Lösung des Problems "Verhinderung von Einschaltimpulsen", die dadurch gekennzeichnet ist, daß eine Funktionseinheit des Schaltverstärkers als UND-Gatter ausgeführt und daß der Anwesenheitsindikator - direkt oder über mindestens eine weitere Funktionseinheit des Schaltverstärkers - an den ersten Eingang des UND-Gatters, die Verzögerungsschaltung an den zweiten Eingang des UND-Gatters angeschlossen ist.

Alle im Stand der Tecknik bekannten Lösungen des Problems "Verhinderung von Einschaltimpulsen" haben den Nachteil, daß sie in bestimmten Situationen Einschaltimpulse doch nicht verhindern, nämlich u. a. dann, wenn entweder das Schaltgerät - z. B. durch prellende Kontakte - mehrfach kurz hintereinander an die Betriebsspannungsquelle angeschlossen wird oder wenn die Betriebsspannungsquelle eine langsam ansteigende Betriebsspannung zur Verfügung stellt. Folglich liegt der Erfindung die Aufgabe zugrunde, das bekannte elektronische Schaltgerät, von dem die Erfindung ausgeht, so auszugestalten und weiterzubilden, daß mit noch größerer Sicherheit Einschaltimpulse verhindert werden.

Das erfindungsgemäße elektronische Schaltgerät, bei dem die zuvor im einzelnen hergeleitete und dargelegte Aufgabe gelöst ist, ist nun zunächst und im wesentlichen dadurch gekennzeichnet, daß die Verzögerungsschaltung erst wirksam wird, nämlich die Verzögerungszeit erst zu laufen beginnt, wenn die Speisespannung einen vorgegebenen Minimalwert erreicht hat, bzw., bei einem elektronischen Schaltgerät mit einer Spannungs- und/oder Stromregler enthaltenden Speiseschaltung, dadurch, daß die Verzögerungsschaltung erst wirksam wird, nämlich die Verzögerungzeit erst zu laufen beginnt, wenn der Spannungs- und/oder Stromregler zu arbeiten begonnen hat. Bei dem erfin dungsgemäßen elektronischen Schaltgerät werden die weiter oben den bekannten elektronischen Schaltgeräten zugeschriebenen Fehlerursachen also dadurch eliminiert. daß die Verzögerungsschaltung erst wirksam wird, nämlich die Verzögerungszeit erst zu laufen beginnt, wenn die Speiseschaltung zur Darstellung der Speisespannung die richtige Speisespannung - für den Oszillator und den Schaltverstärker - zur Verfügung stellt.

Im einzelnen gibt es nun verschiedene Möglichkeiten, das erfindungsgemäße elektronische Schaltgerät auszugestalten und weiterzubilden, was im folgenden nur beispielhaft erläutert werden soll.

In bezug auf die Realisierung der Verzögerungsschaltung ist eine erste Ausführungsform des erfindungsgemäßen elektronischen Schaltgerätes dadurch gekennzeichnet, daß die Verzögerungsschaltung, wie an sich bekannt, als Reihenschaltung aus einem Verzögerungswiderstand und einem Verzögerungskondensator ausgeführt ist. Eine bezüglich der Realisierung der Verzögerungsschaltung bevorzugte Ausführungsform ist jedoch dadurch gekennzeichnet, daß die Verzögerungsschaltung aus einem Verzögerungskondensator und einem der Verzögerungskondensator aufladenden Konstantstromgenerator besteht. Während die Ausgangsspannung am Ausgang der Verzögerungsschaltung dann, wenn diese aus einem Verzögerungswiderstand und einem Verzögerungskondensator besteht, nach einer i-Funktion ansteigt, steigt die Ausgangsspannung am Ausgang der Verzögerungsspanung linear an, wenn die Verzögerungsschaltung aus einem Verzögerungskondensator und einem den Verzögerungskondensator aufladenden Konstantstromgenerator besteht.

Bei der bevorzugten Ausführungsform des erfindungsgemäßen elektronischen Schaltgerätes, bei der die Verzögerungsschaltung aus einem Verzögerungskondensator und einem den Verzögerungskondensator aufladenden Konstantstromgenerator besteht, ist es vorteilhaft, wenn der Konstantstromgenerator einen Stromspiegel, einen Einschalttransistor und einen den Einschalttransistor ansteuernden Auslösetransistor aufweist. Im einzelnen kann dabei die Basis des Auslösetransistors entweder über einen Spannungsteiler an die Steuerspannung oder an einen beim Arbeiten des Spannung- und/oder Stromreglers ein Auslösesignal führenden Anschluß des Spannungs- und/oder Stromreglers angeschlossen sein.

Im übrigen gibt es verschiedene Möglichkeiten, die erfindungsgemäße erst beim Vorliegen einer bestimmten Voraussetzung wirksam werdende Verzögerungsschaltung ihrerseits wirksam werden zu lassen. So kann die Verzögerungsschaltung direkt an den Signalübertragungsweg - zwischen dem Anwesenheitsindikator und dem elektronischen Schalter - angeschlossen sein. Das hat jedoch den in Verbindung mit dem Stand der Technik erläuterten Nachteil. Folglich empfiehlt es sich, die Verzögerungsschaltung, wie an sich bekannt, dem Schaltverstärker bzw. einer Funktionseinheit des Schaltverstärkers speisespannungsmäßig vorzuschalten oder die Verzögerungsschaltung, wie an sich bekannt, den Signalübertragungsweg auf andere Weise zeitverzögert freigeben zu lassen. Insbesondere kann eine Funktionseinheit des Schaltverstärkers als UND-Gatters ausgeführt sein und können der Anwesenheitsindikator - direkt oder über mindestens eine weitere Funktionseinheit des Schaltverstärkers -an den ersten Eingang des UND-Gatters, die Verzögerungsschaltung an den zweiten Eingang des UND-Gatters angeschlossen sein.

Schließlich ist eine bevorzugte Ausführungsform des erfindungsgemäßen elektronischen Schaltgerätes weiter dadurch gekennzeichnet, daß der Ausgang der Verzögerungsschaltung an einen Schwellwertschalter angeschlossen ist und der Schwellwertschalter dann, wenn die Ausgangsspannung am Ausgang der Verzögerungsschaltung einen vorgegebenen Minimalwert erreicht hat, den Schaltverstärker oder die entsprechend Funktionseinheit bzw. die entsprechenden Funktionseinheiten des Schaltverstärkers mit der Speisespannung verbindet oder die entsprechende Funktionseinheit

bzw. die entsprechenden Funktioneinheiten des Schaltverstärkers freigibt.

Im folgenden wird die Erfindung anhand einer lediglich ein Ausführungsbeispiel darstellenden Zeichnung näher erläutert; es zeigt

Fig. 1 ein Blockschaltbild eines elektronischen, berührungslos arbeitenden Schaltgerätes und

Fig. 2 detailliert einen Ausschnitt aus dem Schaltgerät nach Fig. 1, nämlich ein Schaltbild des Spannungsreglers der Speiseschaltung zur Darstellung der Speisespannung für den Anwesenheitsindikator und den Schaltverstärker einerseits, der Einschaltimpulse verhindernden Verzögerungsschaltung andererseits.

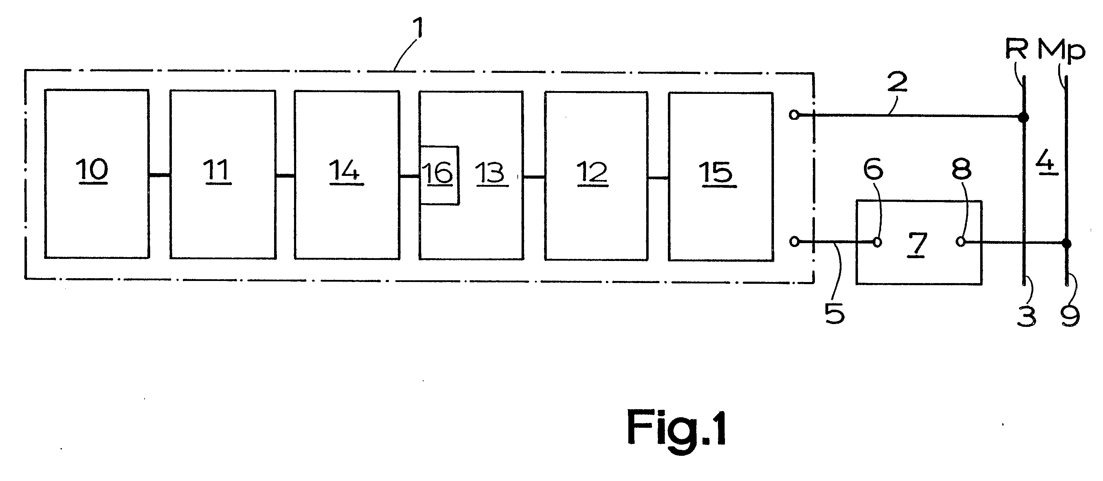

Das in Fig. 1 mit Hilfe eines Blockschalbildes dargestellte elektronische Schaltgerät 1 arbeitet berührungslos, d. h. es spricht z. B. auf ein sich annäherndes, nicht dargestelltes Metallteil an, und ist im dargestellten Ausführungsbeispiel über einen Außenleiter 2 an einen Pol 3 einer Betriebsspannungsquelle 4 und nur über einen weiteren Außenleiter 5 an einen Anschluß 6 eines Verbrauchers 7 angeschlossen, - während der andere Anschluß 8 des Verbrauchers 7 an dem anderen Pol 9 der Betriebsspannungsquelle 4 angeschlossen ist. Mit anderen Worten ist das dargestellte Schaltgerät 1 in bekannter Weise über imsgesamt nur zwei Außenleiter 2, 5 einerseits an die Betriebsspannungsquelle 4 und andererseits an den Verbraucher 7 angeschlossen.

Wie Fig. 1 zeigt, besteht das dargestellte Schaltgerät 1 in seinem grundsätzlichen Aufbau aus einem von außen beeinflußbaren Anwesenheitsindikator 10, z. B. einem Ozillator, einem dem Anwesenheitsindikator 10 nachgeordneten Schaltverstärker 11, einem von dem Anwesenheitsindikator 10 über den Schaltverstärker 11 steuerbaren elektronischen Schalter 12, z. B. einem Thyristor, einer Speiseschaltung 13 zur Darstellung der Speisespannung für den Anwesenheitsindikator 10 und den Schaltverstärker 11 und einer Einschaltimpulse verhindernden Verzögerungsschaltung 14. Eingangsseitig ist noch eine Gleichrichterbrücke 15 vorgesehen, weil es sich bei der Betriebsspannungsquelle 4 um eine Wechselspannungsquelle handelt.

Die Lehre der Erfindung beschäftigt sich nicht mit der Ausgestaltung des Anwesenheitsindikators 10 und des Schaltverstärkers 11, so daß insoweit die Figuren Details nicht zeigen. Für das elektronische Schaltgerät 1 mögliche und bevorzugte Ausführungsformen des Anwesenheitsindikators 10 bzw. des Schaltverstärkers 11 zeigen die DE-OSen 19 51 137, 19 16, 178, 19 16 213, 20 36 840, 22 03 039 und 22 03 040 (für den Anwesenheitsindikator 10) bzw. die DE-OSen 19 51 137 und 22 03 906 (für den Schaltverstärker 11).

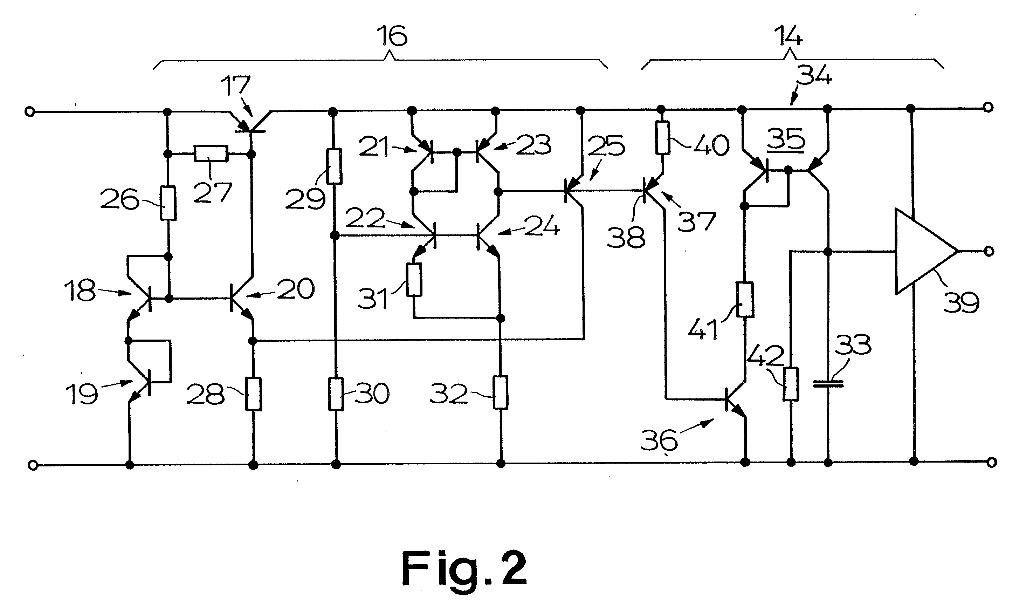

In dem in den Fig. 1 und 2 dargestellten Ausführungsbeispiel eines erfindungsgemäßen elektronischen Schaltgerätes 1 weist die Speiseschaltung 13 zur Darstellung der Speisespannung für den Anwesenheitsindikator 10 und den Schaltverstärker 11 einen Spannungs- und/oder Stromregler 16 auf. Das ist in Fig. 1 nur angedeutet, während Fig. 2 eine mögliche Ausführungsform eines solchen Spannungs- und/oder Stromreglers 16 zeigt. Zu dem in Fig. 2 detaillierter dargestellten Spannungs- und/oder Stromregler 16 gehören Reglertransistoren 17, 18, 19, 20, 21, 22, 23, 24 und 25 sowie Reglerwiderstände 26, 27, 28, 29, 30, 31 und 32.

Erfindungsgemäß ist die Verzögerungsschaltung 14 erst dann wirksam, beginnt nämlich die Verzögerungszeit erst zu laufen, wenn der Spannungs- und/oder Stromregler 16 zu arbeiten begonnen hat. Bei dem erfindungsgemäßen Schaltgerät 1 beginnt also die Verzögerungszeit erst zu laufen, wenn die Speiseschaltung 13 zur Darstellung der Speisespannung die richtige Speisespannung - für den Oszillator 10 und den Schaltverstärker 11 - zur Verfügung stellt.

Im dargestellten Ausführungsbeispiel besteht die - Einschaltimpulse verhindernde - Verzögerungsschaltung 14 aus einem Verzögerungskondensator 33 und einem den Verzögerungskondensator 33 aufladenden Konstantstromgenerator 34. Im einzelnen weist der Konstantstromgenerator 34 einen Stromspiegel 35 auf, ist dem Konstantstromgenerator 34 ein Einschalttransistor 36 zugeordnet und ist der Einschalttransistor 36 von einem Auslösetransistor 37 angesteuert.

Die Basis 38 des Auslösetransistors 37 ist an einen beim Arbeiten des Spannungs- und/oder Stromreglers 16 ein Auslösesignal führenden Anschluß des Spannungs- und/oder Stromreglers 16 angeschlossen, nämlich an die Basis des Reglertransistors 25 angeschlossen.

Im übrigen ist der Ausgang der Verzögerungsschaltung 14 an einen Schwellwertschalter 39 angeschlossen und verbindet der Schwellwertschalter 39 dann, wenn die Ausgangsspannung am Ausgang der Verzögerungsschaltung 14 einen vorgegebenen Minimalwert erreicht hat, den Schaltverstärker 11 mit der Speisespannung.

Schließlich gehören zu der in Fig. 2 im einzelnen dargestellten Verzögerungsschaltung 14 noch ein dem Auslösetransistor 37 zugeordneter Emitterwiderstand 40, ein dem Einschalttransistor 36 zugeordneter Kollektorwiderstand 41 und ein dem Verzögerungskondensator 33 zugeordneter Entladewiderstand 42.

## Ansprüche

1. Elektronisches, vorzugsweise berührunglos arbeitendes Schaltgerät, mit einem von außen beeinflußbaren Anwesenheitsindikator, z. B. einem Oszillator, mit einem dem Anwesenheitsindikator nachgeordneten Schaltverstärker, mit einem von dem Anwesenheitsindikator über den Schaltverstärker steuerbaren elektronischen Schalter, z. B. einem Transistor, einem Thyristor oder einem Triac, mit einer Speiseschaltung zur Darstellung der Speisespannung für den Anwesenheitsindikator und für den Schaltverstärker und mit einer Einschaltimpulse verhindernden Verzögerungsschaltung, **dadurch gekennzeichnet**, daß die Verzögerungsschaltung erst wirksam wird, nämlich die Verzögerungszeit erst zu laufen beginnt, wenn die Speisespannung einen vorgegebenen Minimalwert erreicht hat.

2. Elektronisches, vorzugsweise berührunglos arbeitendes Schaltgerät, mit einem von außen beeinflußbaren Anwesenheitsindikator, z. B. einem Oszillator, mit einem dem Anwesenheitsindikator nachgeordneten Schaltverstärker, mit einem von dem Anwesenheitsindikator über den Schaltverstärker steuerbaren elektronischen Schalter, z. B. einem Transistor, einem Thyristor oder einem Triac, mit einer Spannungs- und/oder Stromregler enthaltenden Speiseschaltung zur Darstellung der Speisespannung für den Anwesenheitsindikator und für den Schaltverstärker und mit einer Einschaltimpulse verhindernden Verzögerungsschaltung, **dadurch gekennzeichnet**, daß die Verzögerungsschaltung (14) erst wirksam wird, nämlich die Verzögerungszeit erst zu laufen beginnt, wenn der Spannungs- und/oder Stromregler (16) zu arbeiten begonnen hat.

3. Elektronisches Schaltgerät nach Anspruch 1 oder 2, dadurch gekennzeichnet, daß die Verzögerungsschaltung, wie an sich bekannt, als Reihenschaltung aus einem Verzögerungswiderstand und einem Verzögerungskondensator ausgeführt ist.

4. Elektronisches Schaltgerät nach Anspruch 1 oder 2, dadurch gekennzeichnet, daß die Verzögerungsschaltung (14) aus einem Verzögerungskonensator (33) und einem den Verzögerungskondensator (33) aufladenden Konstantstromgenerator (34) besteht.

5. Elektronisches Schaltgerät nach Anspruch 4, dadurch gekennzeichnet, daß der Konstantstromgenerator (34) einen Stromspiegel (35) aufweist.

6. Elektronisches Schaltgerät nach Anspruch 4 oder 5, dadurch gekennzeichnet, daß dem Konstantstromgenerator (34) ein Einschalttransistor (36) zugeordnet ist.

7. Elektronisches Schaltgerät nach Anspruch 6, dadurch gekennzeichnet, daß der Einschalttransistor (36) von einem Auslösetransistor (37) angesteuert ist.

8. Elektronisches Schaltgerät nach Anspruch 7, dadurch gekennzeichnet, daß die Basis des Auslösetransistors über einen Spannungsteiler an die Speisespannung angeschlossen ist.

9. Elektronisches Schaltgerät nach Anspruch 7, dadurch gekennzeichnet, daß die Basis (38) des Auslösetransistors (37) an einen beim Arbeiten des Spannungs- und/oder Stromreglers (16) ein Auslösesignal führenden Anschluß des Spannungs- und/oder Stromreglers (16) angeschlossen ist.

10. Elektronisches Schaltgerät nach einem der Ansprüche 1 bis 9, dadurch gekennzeichnet, daß die Verzögerungsschaltung, wie an sich bekannt, direkt an den Signalübertragungsweg - zwischen dem Anwesenheitsindikator und dem elektronischen Schalter - angeschlossen ist.

11. Elektronisches Schaltgerät nach einem der Ansprüche 1 bis 9, dadurch gekennzeichnet, daß die Verzögerungsschaltung (14), wie an sich bekannt, dem Schaltverstärker (11) speisespannungsmäßig vorgeschaltet ist.

12. Elektronisches Schaltgerät nach einem der Ansprüche 1 bis 9, bei dem der Schaltverstärker mehrere Funktionseinheiten aufweist, dadurch gekennzeichnet, daß die Verzögerungsschaltung, wie an sich bekannt, mindestens einer Funktionseinheit des Schaltverstärkers speisespannungsmäßig vorgeschaltet ist.

13. Eletronisches Schaltgerät nach einem der Ansprüche 1 bis 9, bei dem der Schaltverstärker mehrere Funktionseinheiten aufweist, dadurch gekennzeichnet, daß die Verzögerungsschaltung, wie an sich bekannt, den Signalübertragungsweg mindestens einer Funktionseinheit des Schaltverstärkers zeitverzögert freigibt.

14. Elektronisches Schaltgerät nach Anspruch 13, bei dem eine Funktionseinheit des Schaltverstärkers als UND-Gatter ausgeführt ist, dadurch gekennzeichnet, daß der Anwesenheitsindikator - direkt oder über mindestens eine weitere Funktionseinheit des Schaltverstärkers - an den ersten Eingang des UND-Gatters, die Verzögerungsschaltung an den zweiten Eingang des UND-Gatters angeschlossen ist.

15. Elektronisches Schaltgerät nach einem der Ansprüche 1 bis 14, dadurch gekennzeichnet, daß der Ausgang der Verzögerungsschaltung (14) an einen Schwellwertschalter (39) angeschlossen ist und der Schwellwertschalter (39) dann, wenn die Ausgangsspannung am Ausgang der Verzögerungsschaltung (14) einen vorgegebenen Minimalwert erreicht hat, den Schaltverstärker (11) oder die entsprechende Funktionseinheit bzw. die entsprechenden Funktionseinheiten des Schaltverstärkers mit der Speisespannung verbindet oder die entsprechende Funktionseinheit bzw. die entsprechenden Funktionseinheiten des Schaltverstärkers freigibt.

Fig.1

Fig.2

EP 0 298 330 A2